# FASCICULE DE BREVET EUROPEEN

(11) **EP 4 124 871 B1**
(45) Date de publication et mention de la délivrance du brevet: **17.04.2024**
(21) Numéro de dépôt: 22186372.3
(22) Date de dépôt: 22.07.2022
(51) Int. Cl.: G01R 31/28

(54) **DISPOSITIF ET PROCÉDÉ DE TEST DE PUCES ÉLECTRONIQUES**
VORRICHTUNG UND VERFAHREN ZUM TESTEN VON ELEKTRONISCHEN CHIPS
DEVICE AND METHOD FOR TESTING ELECTRONIC CHIPS

(30) Priorité: 29.07.2021 FR 2108250
(43) Date de publication de la demande: 01.02.2023
(73) Titulaire: STMICROELECTRONICS (GRENOBLE 2) SAS, 38000 Grenoble (FR); STMicroelectronics (ALPS) SAS, 38000 Grenoble (FR)
(72) Inventeur: BIDAJ, Klodjan, 38360 Sassenage (FR); ARDAILLON, Benjamin, 38320 Brié-et-Angonnes (FR); GATEKA, Lauriane, 38000 Grenoble (FR)
(74) Mandataire: Cabinet Beaumont

(56) Documents cités:
- TW-A- 201 816 404
- US-A- 6 104 204
- US-A1- 2005 206 368
- US-B1- 6 445 203

## Description

### Domaine technique

La présente description concerne de façon générale des dispositifs de test de puces électroniques et des procédés associés.

### Technique antérieure

Les différentes phases de tests auxquels les puces électroniques sont soumises exigent, avec les dispositifs de test actuels, des manipulations nombreuses directement sur les puces électroniques. Il en ressort un coût élevé et ces manipulations risquent de créer des défaillances.

Par exemple, le document US 6 104 204 A est connu de l'art antérieur et décrit un appareil de test de dispositifs semi-conducteurs auquel est connecté un dispositif de manutention pour transporter des dispositifs semi-conducteurs à des fins de test, et trier les dispositifs semi-conducteurs testés sur la base des résultats des tests.

### Résumé de l'invention

Il existe un besoin d'améliorer les dispositifs existants et les méthodes de tests associées pour permettre, par exemple, d'appliquer différentes phases de tests, comme des tests où les températures sont supérieures à 250°C puis des tests électriques avec ou sans humidité, tout en évitant des manipulations des puces électroniques.

Un mode de réalisation pallie tout ou partie des inconvénients des dispositifs de tests connus.

Un mode de réalisation prévoit un dispositif de test de puces électroniques comprenant une première partie et une deuxième partie, assemblables l'une à l'autre de façon démontable et adaptées à définir entre elles au moins un logement dans lequel au moins une puce électronique, comprenant des éléments de contact, peut être agencée pour être testée ; ledit au moins un logement comprenant une première portion, appartenant à la première partie et dotée d'au moins une première ouverture apte à être traversée par au moins un contacteur électrique externe au dispositif de test ; ledit au moins un logement étant agencé pour permettre à ladite au moins une puce électronique d'occuper : une première position dans ledit logement, dans laquelle une première face de ladite puce électronique, comprenant les éléments de contact, est éloignée de la première portion, et une deuxième position dans ledit logement, dans laquelle la première face est en appui sur la première portion dudit au moins un logement.

Un mode de réalisation prévoit un système de test de puces électroniques, comprenant :
- un tel dispositif de test ;
- un couvercle amovible par rapport au dispositif de test ; et
- une base adaptée à collaborer avec le dispositif de test et le couvercle ;
le dispositif de test, le couvercle et la base étant tels qu'une force soit appliquée sur ladite au moins une puce électronique lorsque la base collabore avec le dispositif de test et le couvercle.

Un mode de réalisation prévoit un procédé de test de puces électroniques comprenant :
- agencer au moins une puce électronique à tester, comprenant des éléments de contact, dans au moins un logement défini entre une première partie et une deuxième partie d'un dispositif de test, les première et deuxième parties étant amovibles l'une par rapport à l'autre, ledit au moins un logement comprenant une première portion, appartenant à la première partie, et dotée d'au moins une première ouverture apte à être traversée par au moins un contacteur électrique externe au dispositif de test ;
- réaliser un premier test de ladite puce électronique avec ladite puce électronique dans une première position dans ledit logement, la première position étant telle qu'une première face de ladite puce électronique, comprenant les éléments de contact, soit éloignée de la première portion ; et
- réaliser un deuxième test électrique de ladite puce électronique avec ladite puce électronique dans une deuxième position dans ledit logement, la deuxième position étant telle que la première face de ladite puce électronique soit en appui sur la première portion dudit au moins un logement.

Selon un mode de réalisation, la deuxième position de ladite au moins une puce électronique est obtenue lorsque le dispositif de test est dans une première orientation dans laquelle une face externe de la première partie du dispositif de test est orientée vers le bas, la face externe comprenant ladite au moins une ouverture ; et la première position est obtenue lorsque la face externe de la première partie du dispositif de test est orientée vers le haut.

Selon un mode de réalisation, dans la première position, la première face de ladite au moins une puce électronique est éloignée de la première portion d'une distance supérieure à 100 micromètres.

Selon un mode de réalisation, la première portion est en forme de grille comprenant plusieurs desdites premières ouvertures.

Selon un mode de réalisation, la première et la deuxième partie du dispositif de test sont adaptées à être fixées ensemble avec au moins un organe de fixation.

Selon un mode de réalisation, le dispositif de test est formé dans un matériau restant dans un état solide à 250°C, par exemple choisi parmi un métal, un alliage métallique, un oxyde, un fluoropolymère, un polyimide et un polyamide.

Selon un mode de réalisation, le couvercle comprend au moins un ergot appliquant ladite force à travers au moins une deuxième ouverture, formée dans une deuxième portion comprise dans ledit au moins un logement, appartenant à la deuxième partie du dispositif de test, lorsque la base collabore avec le dispositif de test et le couvercle.

Selon un mode de réalisation, la base ou le couvercle comprend des bras pivotants aptes à s'engager respectivement avec le couvercle ou la base lorsque ladite base collabore avec le dispositif de test et le couvercle.

Selon un mode de réalisation, le système comprend en outre un circuit imprimé, sur lequel la base est positionnée ; et un circuit de commande de test couplé à au moins un contacteur électrique de la base par l'intermédiaire dudit circuit imprimé.

Selon un mode de réalisation, le deuxième test comprend :
- fournir un couvercle amovible par rapport au dispositif de test ;
- fournir une base, adaptée à collaborer de façon amovible avec le dispositif de test et le couvercle ;
- appliquer une force sur ladite au moins une puce électronique en faisant collaborer ladite base avec le dispositif de test et le couvercle.

Selon un mode de réalisation, le premier test comprend l'application d'une température supérieure à 250°C.

Selon un mode de réalisation, le premier test comprend l'application d'un taux d'humidité supérieur à 60%.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en perspective éclatée d'un mode de réalisation d'un système de test ;
la figure 2 est une vue en coupe d'un mode de réalisation du système de test de la figure 1 ;
la figure 3 est une vue en coupe d'un autre mode de réalisation d'un système de test ;
la figure 4 est une vue en coupe d'un mode de réalisation d'un support du système des figures 1 à 3 ;
la figure 5 est une vue de dessous d'un mode de réalisation d'une première partie du support ;
la figure 6 est une vue de dessus d'un mode de réalisation de la première partie du support ;
la figure 7 est une vue de dessus d'un mode de réalisation d'une deuxième partie du support ;
la figure 8 est une vue de dessous d'un mode de réalisation d'un couvercle du système des figures 1 à 3 ;
la figure 9 est une vue de dessus d'un mode de réalisation d'une base du système des figures 1 à 3 ;
la figure 10 représente un procédé de test selon un mode de réalisation ; et
la figure 11 représente un procédé de test selon un autre mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures dans une position normale d'utilisation.

Sauf précision contraire, les expressions "environ", "approximativement", "sensiblement", et "de l'ordre de" signifient à 10 % près, de préférence à 5 % près.

Les tests réalisés sur les puces électroniques peuvent comprendre des températures supérieures à 250°C ou des tests électriques avec ou sans un taux d'humidité élevé. Pour effectuer les tests, les puces électroniques sont déposées sur des supports de tests. Les différentes conditions de test peuvent entraîner l'utilisation de supports de test différents pour chaque type de test. Les puces électroniques peuvent donc être transférées d'un support à l'autre entre chaque test.

Enlever et manipuler les puces électroniques entre chaque phase de test fait accroître le risque de défaillances par écaillement, par des casses éventuelles, ou encore par endommagement.

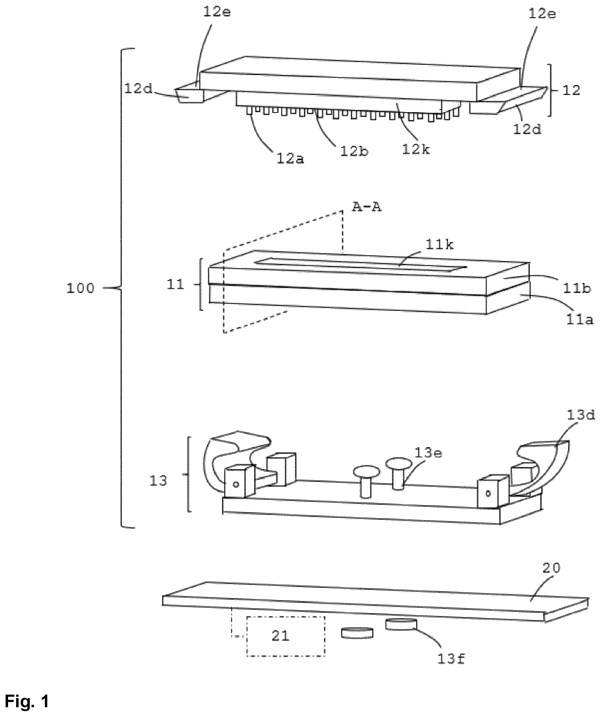

La figure 1 est une vue éclatée en perspective d'un système de test 100 de puces électroniques.

Dans l'exemple de la figure 1, le système de test comprend un couvercle 12, un dispositif de test 11 (ci-après "support") formant un support pour des puce électroniques (non visibles dans la figure 1), et une base 13.

Le support 11 comprend par exemple une première partie 11a et une deuxième partie 11b assemblées l'une à l'autre de manière démontable, donc amovibles l'une par rapport à l'autre. Une ou plusieurs puces électroniques sont maintenues à l'intérieur du support 11.

Dans un exemple, le support 11, et en particulier les première et deuxième parties 11a, 11b du support 11, sont formées dans un matériau restant dans un état solide à 250°C comme par exemple un métal, un alliage métallique, un oxyde, un fluoropolymère, un polyimide et un polyamide. Un tel matériau pourra ainsi supporter l'ensemble des différentes conditions des différents tests, y compris des tests impliquant un chauffage à une température de 250°C ou plus. Cela permet donc d'utiliser un seul et même support 11 pour l'ensemble des phases de test. Dans un exemple de matériau, il est possible d'utiliser un alliage de AlZn₅Mg₃Cu associé à du polyamide-imide renforcé à hauteur de 30% avec des fibres de verre.

Dans l'exemple de la figure 1, le couvercle 12 comprend des ergots 12a saillants perpendiculairement à une face inférieure 12b située vers le bas du couvercle 12 dans l'orientation de la figure 1.

Dans un exemple, le couvercle 12 comprend un épaulement 12k (par exemple longitudinal) agencé pour venir s'engager dans une rainure 11k de la deuxième partie 11b du support 11 lorsque le couvercle 12 et le support 11 collaborent. Cela permet d'améliorer l'alignement entre le couvercle 12 et le support 11.

Le couvercle 12 comprend en outre, dans l'exemple de la figure 1, des moyens de fixation 12d qui sont disposés aux extrémités, par exemple longitudinales, du couvercle 12. Chaque moyen de fixation 12d est par exemple composé d'une surface plane 12e, par exemple horizontale ou orientée avec un angle de quelques degrés par rapport à un plan horizontal du couvercle 12, et dirigée vers l'extérieur du couvercle.

La base 13 peut comprendre, par exemple à ses extrémités longitudinales, des bras pivotants 13d, comportant par exemple une articulation agencée dans un plan horizontal de la base 13 ou dans un plan surélevé par rapport au plan horizontal de la base 13. Les bras pivotants 13d de la base 13 possèdent en outre, par exemple, une extrémité en forme de crochet, configurée pour coopérer, lorsque la base 13 collabore avec le couvercle 12, avec la surface plane 12e des moyens de fixation 12d du couvercle 12 qui sont dans cet exemple fixes.

La base 13 comprend en outre des contacteurs électriques (non visibles sur la figure 1) configurés pour assurer une connexion électrique avec les puces électroniques. Les contacteurs électriques de la base 13 sont par exemple équipés d'aiguilles ou de contacts à ressorts, comme des broches de type POGO, avec des largeurs par exemple de l'ordre de la centaine de micromètres. Dans un exemple, les contacteurs électriques de la base 13 sont agencés avec le même motif que des plots de contact (non visibles) des puces électroniques, et sont donc aptes à assurer un contact électrique avec ces plots de contact.

Le système 100 peut comprendre également, comme sur la figure 1, une carte électrique ou électronique 20 sur lequel la base 13 est positionnée et/ou fixée, par exemple à l'aide d'un système de vis 13e traversant la base 13 et d'écrous 13f. La carte électronique 20 peut être, par exemple, un circuit imprimé. La carte 20 peut en outre comprendre un circuit de commande de test 21 (illustré, pour des causes de lisibilité, en pointillé à l'extérieur de la carte électronique 20 mais dans la réalité compris dans et/ou sur la carte électronique 20). Le circuit de commande de test 21 est par exemple couplé à au moins un des contacteurs électriques de la base 13 par l'intermédiaire de la carte 20. La carte 20 comprend, par exemple, des connecteurs qui peuvent collaborer avec les contacteurs électriques de la base 13 pour amener et recevoir les différents signaux de test jusqu'aux puces électroniques à tester. Le circuit de commande 21 peut ainsi mettre en oeuvre des fonctions de tests qui permettent de tester électriquement les puces électroniques.

Les puces électroniques à tester sont placées sur la partie interne de la première partie 11a ou de la deuxième partie 11b, par exemple avec une technique de placement automatisé (Pick and Place). Puis, la deuxième partie 11b, respectivement la première partie 11a, est rapportée sur la première ou deuxième partie et assemblée (fixée) à celle-ci. Les moyens de fixation sont par exemple répartis autour des puces électroniques à tester. Le support 11 pourra passer ensuite d'une phase de test à l'autre sans que les puces électroniques qu'il contient ne soient manipulées individuellement.

Le support 11 (parties 11a et 11b assemblées) est placé entre la base 13 et le couvercle 12. La base 13 et le couvercle sont prévus pour collaborer, par exemple par les moyens de fixations 12d du couvercle et les bras pivotants 13d de la base.

En fonction des différents tests électriques, le couvercle 12, le support 11 et la base 13 peuvent être désolidarisés, par exemple en enlevant le clip formé entre les moyens de fixation 12d du couvercle 12 et les bras pivotants 13d de la base 13. Le support 11, sans être ouvert, peut ensuite être amené pour une autre phase de test.

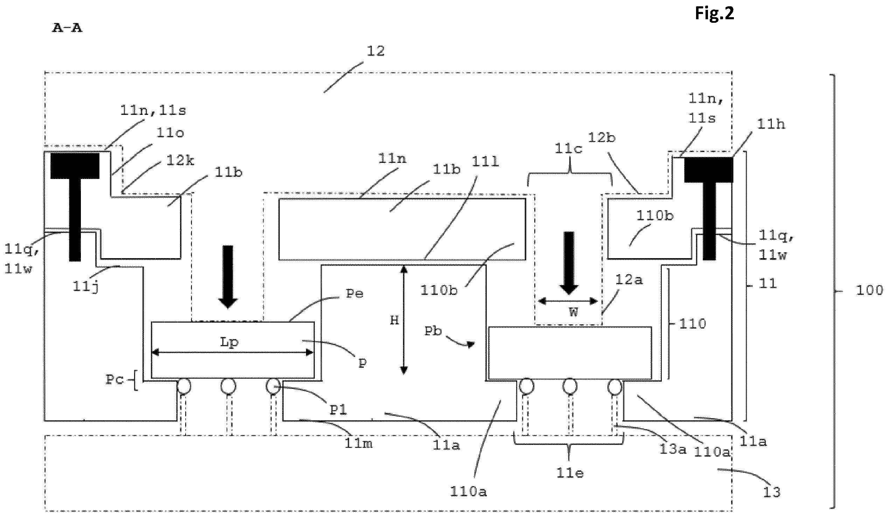

La figure 2 illustre une vue en coupe A-A du système 100 de test de la figure 1. La coupe A-A correspond à une coupe transversale dans une largeur du support 11. L'exemple de la figure 2 illustre une configuration dans laquelle des tests électriques peuvent être réalisés sur les puces électroniques P, et dans laquelle le support 11 est tenu entre la base 13 et le couvercle 12.

Dans l'exemple de la figure 2, la première partie 11a et la deuxième partie 11b du support 11 sont mises en contact. La première partie 11a et la deuxième partie 11b délimitent entre elles, au niveau de la coupe A-A, deux logements 110 dans la largeur du support 11. Une puce électronique P est placée à l'intérieur de chaque logement 110.

Dans d'autres modes de réalisation, le support 11 peut comporter un seul logement 110 ou plus de deux logements 110, par exemple des dizaines ou des centaines de logements dans le plan de la coupe A-A. La coupe A-A représente une rangée de logements 110. Plusieurs rangées de logements 110 peuvent être disposées dans la longueur du support 11, chaque rangée comprenant un ou plusieurs logements. Le fait de prévoir plusieurs logements 110 dans le support 11, par exemple des dizaines ou des centaines de logements 110, permet de baisser les coûts des tests, car plusieurs puces électroniques peuvent être testées au même temps.

Chaque logement 110 est par exemple délimité, en partie basse dans l'orientation de la figure 2, par une portion 110a qui appartient à la première partie 11a. Dans cet exemple, la portion 110a de chaque logement 110 comprend une seule ouverture 11e qui relie le logement 110 à une face extérieure 11m (opposée à la partie 11b) de la première partie 11a.

Chaque logement 110 est par exemple délimité, en partie haute dans l'orientation de la figure 2, par une portion 110b qui appartient à la deuxième partie 11b. Dans cet exemple, la portion 110b de chaque logement 110 comprend une seule ouverture 11c qui relie le logement 110 à une face extérieure 11n (opposée à la partie 11a) de la deuxième partie 11b.

L'ouverture 11e et l'ouverture 11c peuvent être, vues de dessus, de forme carrée, rectangulaire ou polygonale, ou encore être de forme circulaire ou elliptique. Les ouverture 11e et 11c peuvent être centrées l'une par rapport à l'autre, par exemple partager un même axe vertical en cas d'ouvertures circulaires. Les dimensions des ouvertures 11e ou 11c sont par exemple inférieures aux dimensions longitudinales Lp des puces électroniques P de sorte qu'une puce électronique P, lorsqu'elle est dans un des logements 110, ne peut pas traverser les ouvertures 11e ou 11c et reste donc emprisonnée au sein du logement 110. De façon additionnelle, les dimensions des ouvertures 11e ou 11c peuvent être inférieures aux dimensions des puces électroniques prises dans un axe perpendiculaire à leur axe longitudinal. Plus généralement, une des dimensions des ouvertures 11e et 11c, dans les plans respectifs des faces externes des parties respectives 11a et 11b, est inférieure à une des dimensions des puces électronique dans la même direction.

Chaque logement 110 a des dimensions, mesurées dans un plan horizontal de la première partie 11a, supérieures à celles des ouvertures 11e ou 11c. Par exemple, le logement 110 est plus large que les ouvertures 11c et 11e. La largeur du logement 110 est en outre au moins légèrement supérieure, par exemple entre 40 et 100 micromètres à celle des puces électronique P, et par exemple supérieure d'environ 50 micromètres à celle des puces électroniques P. Cela permet qu'une puce électronique P puisse être insérée facilement dans le logement 110 tout en étant maintenue, de façon lâche, en position horizontale.

La portion 110a définit, dans l'exemple de la figure 2, un épaulement qui vient en saillie à l'intérieur du logement 110 au niveau d'une partie basse du logement 110.

La portion 110b définit, dans l'exemple de la figure 2, un épaulement qui vient en saillie à l'intérieur du logement 110 au niveau d'une partie haute du logement 110.

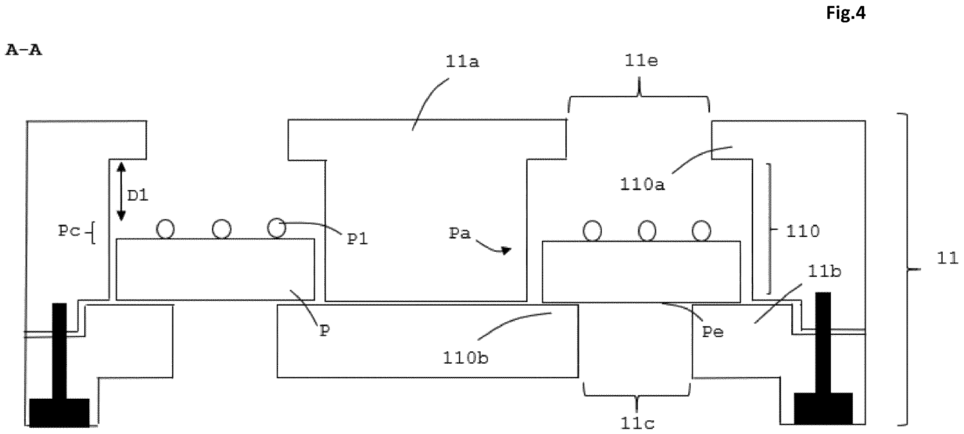

La figure 2 illustre une position de test électrique Pb des puces électroniques P au sein des logements 110. Dans cette position, chaque puce électronique P est en appui sur la première portion 110a du logement 110 correspondant. Chaque puce électronique P peut également occuper, au sein du logement 110, une position de sécurité (décrite ci-dessous en relation avec la figure 4), dans laquelle la puce électronique P est éloignée de la première portion 110a. Cela est par exemple possible du fait que la hauteur H des logements 110 est supérieure à une hauteur des puces électroniques P.

Dans l'exemple de la figure 2, la première partie 11a comporte en outre une face d'appui 11q en contact de laquelle vient s'appuyer la deuxième partie 11b du support 11. Dans un exemple illustré sur la figure 2, une rainure 11j est réalisée dans la première partie 11a à partir de la face d'appui 11q. La face d'appui 11q comprend donc des portions 11w, illustrées aux extrémités gauche et droite de la première partie 11a sur la figure 2, de chaque côté de la rainure 11j. Dans cet exemple, la rainure 11j s'étend de façon à dépasser, dans un plan longitudinal du support 11, de chaque côté des logements 110. La rainure 11j permet, par exemple, d'abaisser l'épaisseur de la première partie 11a au niveau des logements 110 afin que la hauteur H ne soit pas trop élevée, tout en gardant une faible épaisseur de la première portion 110a. La hauteur H reste donc limitée pour permettre une insertion aisée et sécurisée des puces électroniques P dans les logements 110.

Dans l'exemple de la figure 2, chaque puce électronique P à tester est formée d'un circuit intégré, ou d'un empilement de plusieurs circuits intégrés dans le cas d'un dispositif en technologie 3D, encapsulé par exemple dans un boîtier. Le boîtier d'encapsulement est par exemple de type WLCSP (de l'anglais Wafer Level Chip Scale Packaging). Dans cet exemple, trois éléments de contact P1, en forme de boule, s'étendent, dans la direction de la coupe de la figure 2, à l'extérieur du boîtier de chaque puce électronique P. Le nombre d'éléments de contact P1 peut être compris, dans d'autres exemples non illustrés, entre 2 et plusieurs dizaines ou centaines.

Dans un autre exemple, les éléments de contact P1 peuvent avoir une forme différente d'une boule, par exemple une forme de pavé, ou bien être affleurant par rapport au boîtier d'encapsulement. Dans un exemple, les boules sont formées sur des plots de contact présents sur la puce électronique P. Dans certains cas, ces plots de contact peuvent former directement les éléments de contact P1, sans l'utilisation de boules.

Les éléments de contact P1, et une portion de la puce électronique P sur laquelle les éléments de contact P1 sont agencés, forment une face d'appui Pc des puces électroniques P. Dans la position de test électrique Pb, la face d'appui Pc est en appui sur la portion 110a du logement 110. Les éléments de contacts P1 peuvent ainsi pénétrer dans les ouvertures 11e. La portion de la puce électronique P sur laquelle les éléments de contact P1 sont agencés est, elle, bloquée en appui avec l'épaulement formé par la portion 110a.

Dans l'exemple de la figure 2, la deuxième partie 11b du support 11 comprend une face inférieure 11l, par exemple, plane. La face supérieure 11n de la deuxième partie 11b comprend par exemple une rainure 11o. La face supérieure 11n comprend donc des portions 11s, illustrées aux extrémités gauche et droite de la deuxième partie 11b sur la figure 2, de chaque côté de la rainure 11o. Dans cet exemple, la rainure 11o s'étend de façon à dépasser, dans un plan longitudinal du support 11, de chaque côté des ouvertures 11c. La rainure 11o permet, par exemple, d'améliorer l'alignement entre le support 11 et le couvercle 12 en collaborant avec l'épaulement 12k du couvercle 12.

La première et la deuxième partie 11a, 11b du support 11 peuvent être fixées ensemble avec au moins un organe de fixation 11h, par exemple des vis. Cela permet de solidariser de façon réversible la première et la deuxième partie 11a, 11b du support 11.

Dans l'exemple de la figure 2, le couvercle 12 vient collaborer avec la face supérieure 11n du support 11 de sorte que deux parmi les ergots 12a entrent respectivement dans les deux ouvertures 11c. Les ergots 12a ont une largeur W qui est inférieure aux dimensions des ouvertures 11c pour pouvoir les traverser. Les ergots 12a ont une extension verticale qui permet de venir en contact avec une face Pe des puces électroniques P, la face Pe étant par exemple opposée et parallèle à la face Pc qui contient les éléments de contact P1. Les ergots 12a permettent ainsi d'appliquer une force, représentée par des flèches dans la figure 2, sur les puces électroniques P, vers les ouvertures 11e et donc vers les contacteurs électriques de la base. La force appliquée par les ergots 12a est par exemple obtenue lorsque le couvercle est tenu par les bras pivotants 13d de la figure 1, la base 13 et le couvercle 12 étant, par exemple, adaptés pour être clipsés ensemble lorsque ladite base 13 collabore avec le support 11 et le couvercle 12. Dans un exemple, la force est appliquée en direction d'un axe d'au moins un des contacteurs électriques de la base 13. Cela permet d'améliorer les contacts électriques entre les contacteurs électriques de la base et les éléments de contact des puces électroniques.

Dans l'exemple de la figure 2, la base 13 vient collaborer avec la face inférieure 11m du support 11. Trois contacteurs électriques 13a de la base 13 sont illustrés dans l'exemple de la figure 2, et traversent chaque ouverture 11e du support 11.

Les différentes phases de test sont réalisées avec un seul même support 11, qui est par exemple transféré de station de test en station de test. Cela permet d'éviter les manipulations sur les puces électroniques directement.

Dans un exemple de mise en oeuvre de la phase de test électrique, les puces électroniques P sont d'abord placées, par exemple par technique automatisée (Pick and Place), sur les premières portions 110a des logements 110. Puis, la deuxième partie 11b du support 11 est assemblée avec la première partie 11a. Les puces électroniques P sont ainsi gardées emprisonnées, mais avec un degré de liberté, au sein des logements 110. Le support 11 peut ainsi être transporté entre chaque phase de test, sans être ouvert.

Pour les phases de test électriques, la base 13 est fixée sur un circuit électronique (non illustré sur la figure 2). Le support 11, orienté avec sa première partie 11a vers le bas, est mis en contact de la base 13. Les contacteurs électriques de la base 13 traversent alors les ouvertures 11e pour venir créer un contact électrique avec les éléments de contact P1 des puces électroniques P.

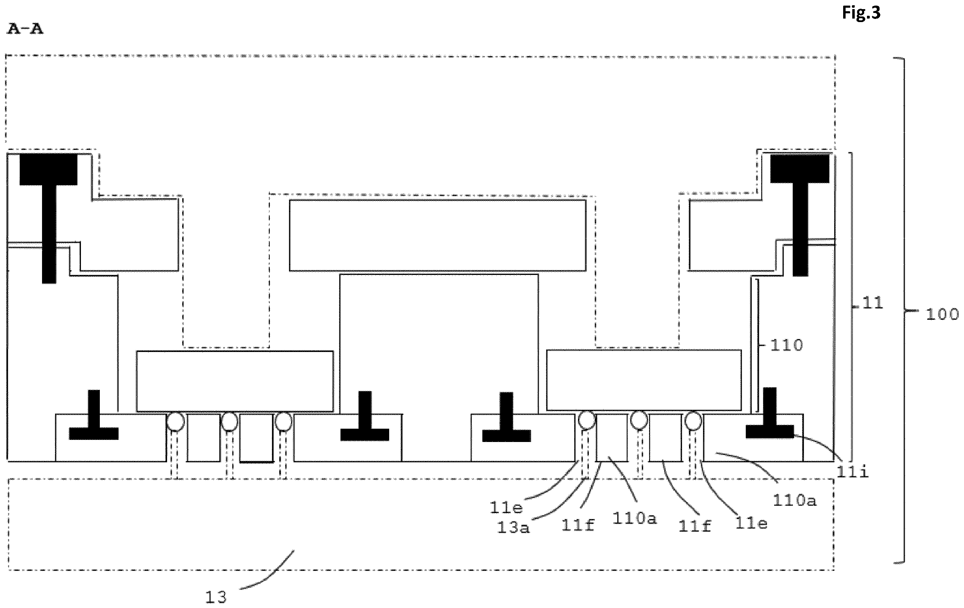

La figure 3 est une vue en coupe d'un mode de réalisation du système 100 de test identique à celui de la figure 2, à part le fait que la première portion 110a des logements 110 est en forme de grille 11f, qui comprend plusieurs des ouvertures 11e. Autrement dit, plusieurs ouvertures 11e débouchent vers chaque logement 110. Les ouvertures 11e ont, par exemple, le même schéma d'agencement que le schéma d'agencement des éléments de contact P1 des puces électroniques P. Ainsi, lorsque les puces électroniques P sont dans la position de test électrique Pb, les éléments de contact P1 sont, par exemple, au moins en partie insérés chacun dans une des ouvertures 11e de la grille 11f. Cela permet de stabiliser et fiabiliser les contacts électriques au niveau des ouvertures 11e. Cela permet en outre de guider les contacteurs électriques 13a de la base 13, notamment si ces contacteurs électriques 13a ont une forme conique ou arrondie à leur extrémité de contact.

Dans l'exemple de la figure 3, la première portion 110a, comprenant la grille 11f de chaque logement 110, est fixée à la première partie 11a par des vis 11i. Bien que ces vis 11i soient illustrées dans la figure 3 pour compréhension, elles ne sont en pratique pas nécessairement placées dans le plan de la coupe A-A. Ces vis 11i permettent de changer les premières portions 110a, y compris les grilles 11f, en fonction de la forme ou du schéma d'agencement des éléments de contact P1 des puces électroniques. Il serait possible, dans le mode de réalisation de la figure 2, que les premières portions 110a soient également amovibles d'une manière similaire.

La configuration des figures 2 et 3 peut également servir à des tests à taux d'humidité élevé. Par taux d'humidité élevé, on entend un taux supérieur à 60%, par exemple 85%.

La figure 4 est une vue en coupe d'un mode de réalisation du support 11 de la figure 2 selon une configuration utilisée pour une phase de test comprenant l'application d'une haute température. Par haute température, on entend par exemple une température supérieure à 250°C. Pour de telles phases de tests, le couvercle et la base ne sont pas utilisés.

Dans l'exemple de la figure 4, le support 11 est mis dans une orientation renversée, par opposition à une orientation dite arbitrairement "normale" comme en figures 2 et 3. Cette orientation renversée du support 11 est obtenue, dans cet exemple, avec la première partie 11a du support 11 orientée vers le haut et la deuxième partie 11b vers le bas. Dans cette orientation, les puces électroniques P sont dans une position de sécurité Pa au sein des logements 110 de par l'action de la gravité. La face Pc des puces électroniques P est alors éloignée de la première portion 110a et la face Pe des puces électroniques P est en appui sur l'épaulement formé par la portion 110b. Cela permet d'éviter tout contact entre les éléments de contact P1 et les surfaces du support 11. En effet, l'application d'une température supérieure à 250°C provoque, ou risque de provoquer, une refusion (en anglais "reflow") des éléments de contact P1, ce qui peut poser problème si ces éléments de contact P1 sont proches des surfaces intérieures du support 11.

Dans un exemple, lorsque chaque puce électronique P est dans la position de sécurité Pa, la face Pc de la puce est éloignée de la portion 110a d'une distance D1 supérieure à 100 micromètres.

La configuration de la figure 4 peut également servir à des tests à taux d'humidité élevé. En effet, les ouvertures 11e, et/ou les ouvertures 11c, permettent d'introduire de l'humidité au niveau des logements 110 et donc au niveau des puces électroniques P.

Bien entendu, le support 11 illustré en figures 2 et 3 peut également être utilisé dans l'orientation de la figure 4, avec les mêmes avantages, par exemple lors de tests à taux d'humidité élevé.

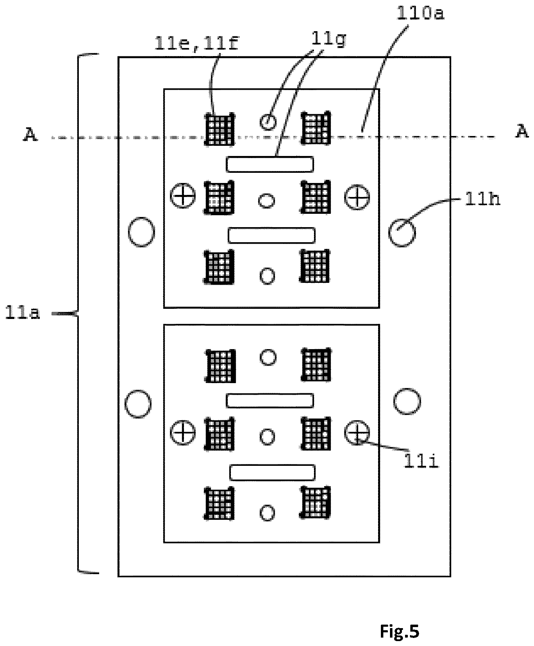

Des exemples de réalisation du support 11, du couvercle 12 et de la base 13 vont maintenant être décrits en relation avec les figures 5 à 9.

La figure 5 est une vue de dessous de la première partie 11a du support 11 de la figure 3, comprenant les grilles 11f.

La première partie 11a du support 11, dans l'exemple de la figure 5, comporte deux grilles 11f au niveau de la coupe A-A et dix autres grilles disposées parallèlement suivant un plan longitudinal de la première partie 11a.

Dans l'exemple de la figure 5, il y a deux portions 110a, individuellement amovibles, et comportant chacune six grilles parmi les grilles 11f. Chaque portion 110a est par exemple fixée par deux éléments de fixation 11i ou plus.

Des organes d'alignement 11g du support 11 sont présents au niveau de la première portion 110a et permettent un alignement entre le support 11 et la base 13. Dans un exemple, ils consistent en des portions ouvertes dans lesquelles des organes d'alignement mâles correspondants de la base 13 peuvent s'insérer.

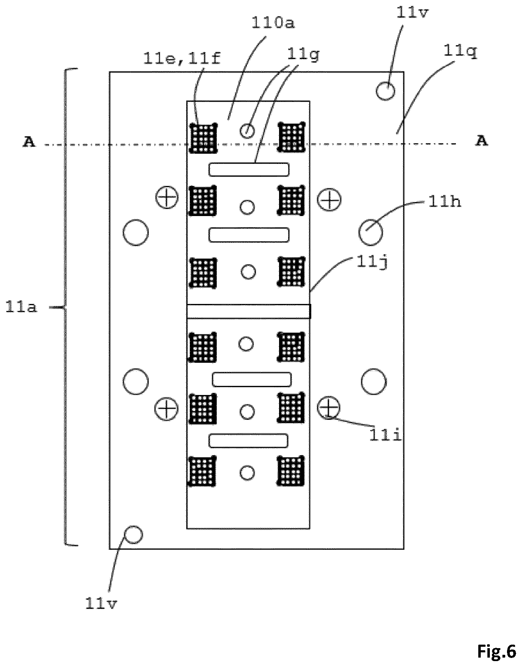

La figure 6 est une vue de dessus d'un exemple de la première partie 11a du support 11 de la figure 3.

Dans l'exemple de la figure 6, la tranchée 11j s'étend au-dessus de l'ensemble des grilles 11f. Des cavités 11v sont également présentes dans des coins opposés en diagonale de la première partie 11a. Elles s'étendent depuis la face d'appui 11q dans la première partie 11a.

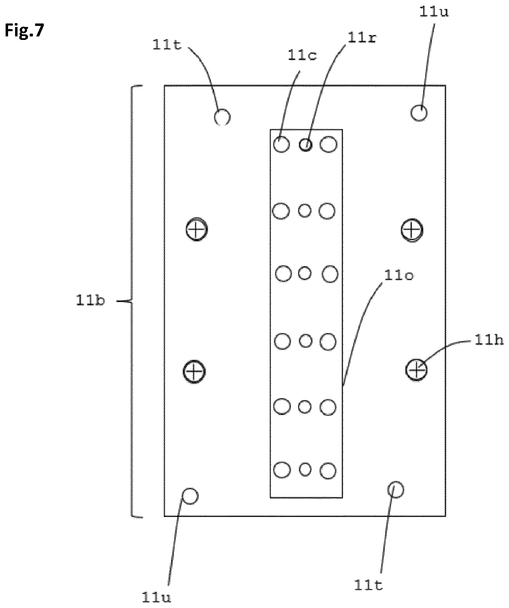

La figure 7 est une vue de dessus d'un exemple de la deuxième partie 11b du support 11.

Dans l'exemple de la figure 7, les ouvertures 11c sont formées à travers la rainure 11o de la deuxième partie 11b comme sur l'exemple de la figure 2. De plus, la deuxième partie 11b comprend, par exemple, des ouvertures supplémentaires 11r. Ces éléments 11r sont agencés pour permettre la pénétration d'humidité. Ces éléments 11r sont, par exemple, agencés pour être en regard des éléments d'alignement 11g de la première partie 11a lorsque les premières et deuxièmes parties 11a, 11b du support 11 sont fixées ensemble.

Dans l'exemple de la figure 7, les têtes des organes de fixation 11h sont visibles, ces organes permettant de fixer ensemble la première et la deuxième partie, comme dans l'exemple de la figure 2. De plus, des cavités d'alignement 11t sont par exemple agencées dans des coins opposés en diagonale de la deuxième partie 11b. Des pions d'alignement 11u sont par exemple également présents dans les coins restants et opposés en diagonale de la deuxième partie 11b. Ces pions d'alignement 11u sont agencés dans des trous traversant, et sont donc visible dans la vue de dessus de la figure 7. Ces pions 11u sont agencés pour collaborer, par exemple, avec les cavités 11v de la première partie 11a.

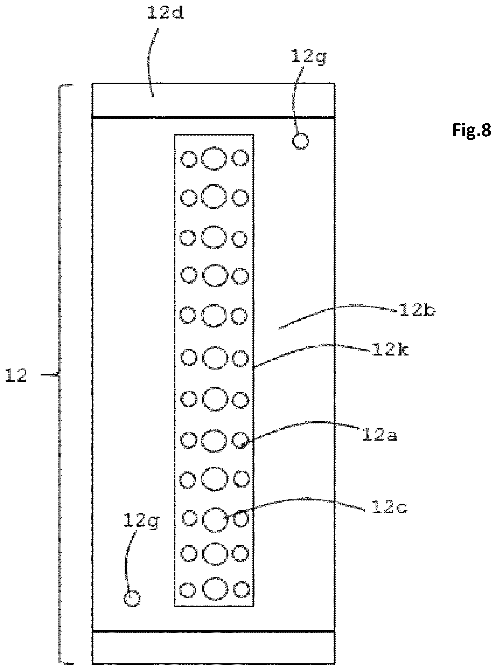

La figure 8 illustre une vue de dessous d'un exemple de couvercle 12 des figures 1 à 3.

Dans l'exemple de la figure 8, le couvercle 12 comprend des organes d'alignements 12g formés par des pions saillants de la face inférieure 12b du couvercle 12. Ils collaborent, par exemple, avec les cavités d'alignement 11t de la deuxième partie 11b du support 11 lorsque le couvercle 12 et le support 11 collaborent.

Dans l'exemple de la figure 8, l'épaulement 12k comprend 24 ergots 12a permettant de collaborer avec un support comprenant un nombre correspondant de logements 110. La personne du métier comprendra comment adapter le nombre d'ergots 12a sur le couvercle au nombre de logements dans le support 11.

Dans l'exemple de la figure 8, des ouvertures 12c sont formées à travers le couvercle 12 dans des régions entre les ergots 12a. Elles permettent de faciliter la pénétration de l'humidité et de la température vers les puces électroniques.

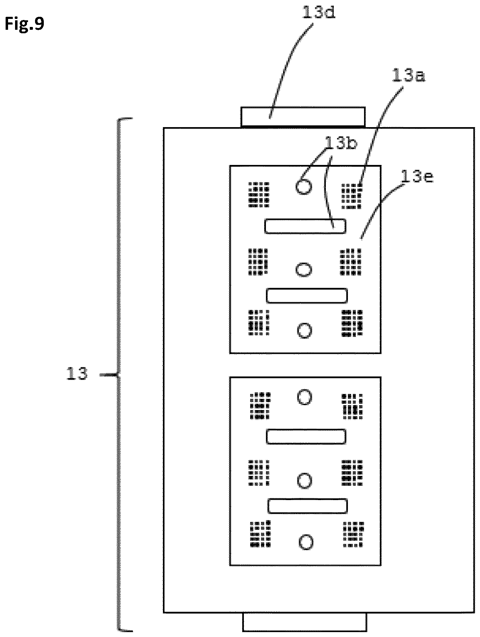

La figure 9 illustre un exemple de la base 13 des figures 1 à 3, en vue de dessus.

La base 13 comprend par exemple des organes d'alignement 13b agencés sous forme de plots pour venir collaborer avec des organes d'alignement 11g situés au niveau du support 11 lorsque la base 13 et le support 11 collaborent.

Les contacteurs électriques 13a sont visibles dans la vue de la figure 9. Ces contacteurs électriques 13a sont, par exemple, agencés sur des plaques amovibles 13e. Cela permet, par exemple, d'interchanger les plaques en fonction du type de puces électroniques, sans avoir à changer l'ensemble de la base 13.

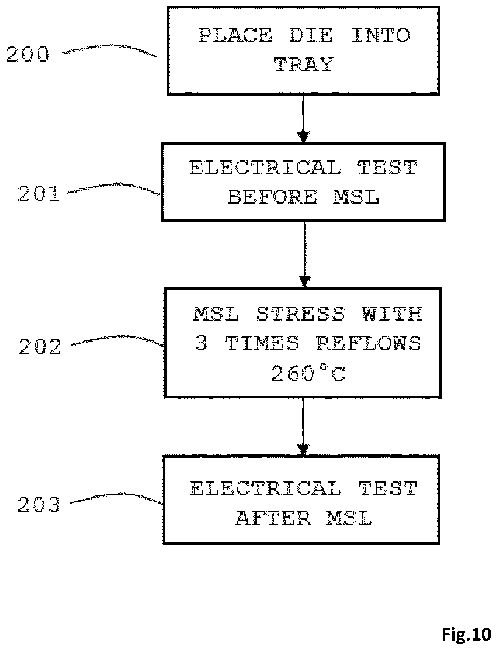

La figure 10 illustre un exemple de procédé de test des puces électroniques P.

Dans une étape 200 (PLACE DIE INTO TRAY), les puces électroniques à tester sont introduites, par exemple de manière automatisée (Pick and Place), dans les logements 110 du support 11.

De préférence, l'étape 200 est suivie d'une étape 201 de test électrique (ELECTRICAL TEST BEFORE MSL). Cette étape peut cependant être omise.

Puis, dans une étape 202 (MSL STRESS WITH 3 TIMES REFLOWS 260°C), le support 11 est placé dans son orientation renversée comme décrit en relation avec la figure 4. Les puces électroniques sont donc dans la position de sécurité Pa dans les logements 110. Le support 11 est ensuite placé dans un four, à une température par exemple de 260°C, ce qui provoque par exemple une refusion des éléments de contact P1 des puces électronique. Dans un exemple, ce test comprend l'application de trois phases de refusion. Dans un exemple, ce test peut comprendre en outre l'application d'un taux d'humidité élevé, par exemple supérieur à 60%, afin d'effectuer un test de résistance à l'humidité (en anglais "Moisture Sensitivity Level", ou "MSL").

Dans une étape 203 (ELECTRICAL TEST AFTER MSL), le support 11 est mis dans son orientation normale et les puces électroniques dans la position de test électrique Pb. Le support 11 est ensuite mis au sein du système 100 de test, comme dans les exemples des figures 2 ou 3. Au moins un test électrique est réalisé.

Dans un autre mode de réalisation, l'étape 203 peut avoir lieu avant l'étape 202.

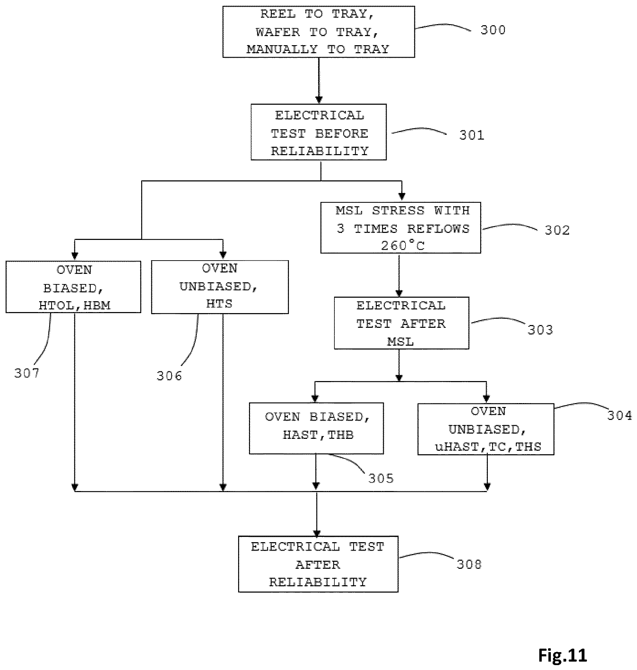

La figure 11 illustre un autre exemple de procédé de test des puces électroniques.

Dans une étape 300 (REEL TO TRAY, WAFER TO TRAY, MANUALLY TO TRAY), les puces électroniques à tester sont introduites dans le support 11. Par exemple, les puces électroniques sont introduites de manière automatisée à partir d'une bande (REEL TO TRAY), qui fonctionne comme support pour plusieurs puces électroniques P. Dans un autre exemple, les puces électroniques proviennent d'une galette (« Wafer » en anglais) (WAFER TO TRAY). Les puces électroniques peuvent également être transférées manuellement vers le support 11 (MANUALLY TO TRAY).

Dans une étape 301 (ELECTRICAL TEST BEFORE RELIABILITY), un test électrique est réalisé avec un système 100 de test, similaire au test 203 de la figure 10.

A la suite de l'étape 301, plusieurs tests ou séries de tests sont possiblement effectuées individuellement ou en combinaison, comme par exemple une série de tests 302, 303, 304, ou une série de tests 302, 303, 305, ou un test 306 ou bien encore un test 307.

Le test 302 (MSL STRESS WITH 3 TIMES REFLOWS 260°C) est identique au test 202 de la figure 10. Le test effectué à l'étape 303 (ELECTRICAL TEST AFTER MSL) est similaire à celui de l'étape 301. Dans le test 304 (OVEN UNBIASED uHAST, TC,THS) le support 11 est par exemple désolidarisé de la base 13 et du couvercle 12 utilisés dans l'étape 303. Ce test consiste, par exemple, en un test accéléré sans polarisation des puces (en anglais "Unbiased Highly Accelerated Stress Test", ou "uHAST"), ou bien en des cycles de température (en anglais "Temperature Cycling", ou "TC") ou bien encore en une combinaison de tests en température, humidité et de stockage (en anglais « Température, Humidity, Storage », « THS »). Le test uHAST peut comprendre, par exemple, l'application d'une température comprise entre 130 et 150°C, l'application d'un taux d'humidité supérieur à 70%, par exemple à 85%, l'application d'une pression supérieure à 2 bars, ou toute combinaison de ces paramètres. Le test TC peut comprendre une phase où la température appliquée varie entre -40°C et 85°C ou entre -40°C et 125°C pendant plusieurs cycles, par exemple plusieurs centaines ou milliers de cycles.

L'étape 304 est facultative. Lorsqu'elle prévue, tout ou partie des tests (OVEN UNBIASED uHAST,TC,THS) de l'étape 304 peuvent être réalisés. En outre, leur exécution peut être séparée ou simultanée.

Le test 305 (OVEN BIASED,HAST,THB) est un test électrique réalisé sur un système 100 de test avec les puces électriques dans la position de test électrique Pb. Ce test est par exemple un test accéléré avec polarisation des puces (en anglais "Highly Accelerated Stress Test", ou "HAST"). Par exemple, ce test peut comprendre une phase où la température est au-dessus de 125°C, en appliquant une tension d'alimentation supérieure à la tension d'alimentation nominale des puces électroniques au niveau de leurs éléments de contact P1. Le test peut en outre comprendre une autre phase où la température est maintenue au-delà de 125°C, avec un taux d'humidité supérieur à 70%, par exemple à 85%, et une pression supérieure à 2 bars, tout en appliquant aux éléments de contact P1 une tension supérieure à la tension d'alimentation nominale des puces électroniques. Dans un exemple, le test 305 comprend un test accéléré avec polarisation des puces (en anglais « Température, Humidity, Bias », ou « THB »).

Dans le test 306 (OVEN UNBIASED, HTS), le support 11 est par exemple désolidarisé de la base 13 et du couvercle 12 utilisés dans l'étape 301. Ce test est par exemple un test de stockage à température élevée (en anglais "High Température Storage", ou "HTS"). Ce test peut comprendre, par exemple, l'application d'une température comprise entre 130 et 150°C.

Le test 307 (OVEN BIASED, HTOL, HBM) est un test électrique réalisé sur un système 100 de test avec les puces électriques dans la position de test électrique Pb. Le test HTOL consiste en un test de la vie de fonctionnement à haute température (en anglais "High Température Operating Life", ou "HTOL"). Le test HBM (de l'anglais « Human Body Model ») consiste en un test reproduisant un modèle de décharge électrostatique (en anglais « Electrical discharge » ou ESD) de corps humain avec l'emploi de décharges électrostatiques.

L'étape 307 est facultative. Lorsqu'elle est prévue, tout ou partie des tests (OVEN BIASED, HTOL, HBM) de l'étape 307 peuvent être réalisés. Eu outre, leur exécution peut être séparée ou simultanée. Dans un exemple, les tests (OVEN BIASED, HTOL, HBM) de l'étape 307 sont réalisés avec différents supports de carte pour la base 13.

Après l'étape 304, l'étape 305, l'étape 306 ou l'étape 307, un autre test électrique est par exemple réalisé dans une étape 308 (ELECTRICAL TEST AFTER RELIABILITY). Ce test est similaire au test réalisé dans les étapes 301 et 303, mais peut être effectué sur une base 13 différente.

En proposant un support en deux parties dans lequel des puces électroniques peuvent aisément être placées de façon automatisée avant d'être testées, on permet que les puces électroniques, une fois disposées dans le support, ne soient ensuite plus manipulées directement. Le support reste le même pour les différentes phases de tests, qu'il s'agisse de tests où la température est supérieure à 250°C ou des tests électriques avec ou sans humidité et température. Seule l'orientation du support change par exemple entre les différentes phases de test pour permettre aux puces électroniques d'adopter des positions différentes. Cela permet de limiter les manipulations des puces électroniques et limite donc les causes de défaillances. Au contraire, c'est le support qui est manipulé entre les différentes phases de tests. La structure du support permet en outre que les puces électroniques puissent se mouvoir à l'intérieur, en fonction du test réalisé, afin que les éléments de contact n'adhèrent pas à des surfaces du support.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

Par exemple, lors des tests électriques, la base peut être agencée vers le haut avec ses contacteurs électriques pointant vers le bas. Les premières et deuxièmes parties du support peuvent être alors être agencées de sorte que les contacteurs électriques de la base soient introduits vers des ouvertures 11e du support débouchant vers le haut. Dans ce cas, le couvercle peut être placé sous le support. Les ergots du couvercle pointent alors vers le haut de sorte à pénétrer dans des ouvertures 11c du support débouchant vers le bas.

Dans un autre exemple, les ouvertures 11e peuvent être remplies en tout ou partie par un conducteur électrique pour former un contact intermédiaire entre les contacteurs électriques de la base d'une part et les éléments de contact des puces électronique d'autre part.

## Revendications

1. Dispositif de test (11) de puces électroniques (P) comprenant :
une première partie (11a) et une deuxième partie (11b), assemblables l'une à l'autre de façon démontable et adaptées à définir entre elles au moins un logement (110) dans lequel au moins une puce électronique (P), comprenant des éléments de contact (P1), peut être agencée pour être testée ;
ledit au moins un logement (110) comprenant une première portion (110a), appartenant à la première partie (11a) et dotée d'au moins une première ouverture (11e) apte à être traversée par au moins un contacteur électrique (13a) externe au dispositif de test (11) ;
ledit au moins un logement (110) étant agencé pour permettre à ladite au moins une puce électronique (P) d'occuper :
une première position (Pa) dans ledit logement (110), dans laquelle une première face (Pc) de ladite puce électronique (P), comprenant les éléments de contact (P1), est éloignée de la première portion (110a), et
une deuxième position (Pb) dans ledit logement (110), dans laquelle la première face (Pc) est en appui sur la première portion (110a) dudit au moins un logement (110).

2. Système (100) de test de puces électroniques (P), comprenant :
- le dispositif de test (11) selon la revendication 1 ;
- un couvercle (12) amovible par rapport au dispositif de test (11) ;
- une base (13) adaptée à collaborer avec le dispositif de test (11) et le couvercle (12) ;
le dispositif de test (11), le couvercle (12) et la base (13) étant tels qu'une force soit appliquée sur ladite au moins une puce électronique (P) lorsque la base (13) collabore avec le dispositif de test (11) et le couvercle (12) .

3. Procédé de test de puces électroniques (P) comprenant :
- agencer au moins une puce électronique (P) à tester, comprenant des éléments de contact (P1), dans au moins un logement (110) défini entre une première partie (11a) et une deuxième partie (11b) d'un dispositif de test (11), les première et deuxième parties (11a, 11b) étant amovibles l'une par rapport à l'autre, ledit au moins un logement (110) comprenant une première portion (110a), appartenant à la première partie (11a), et dotée d'au moins une première ouverture (11e) apte à être traversée par au moins un contacteur électrique (13a) externe au dispositif de test (11) ;
- réaliser un premier test (202) de ladite puce électronique (P) avec ladite puce électronique (P) dans une première position (Pa) dans ledit logement (110), la première position (Pa) étant telle qu'une première face de ladite puce électronique (P), comprenant les éléments de contact (P1), soit éloignée de la première portion (110a) ; et
- réaliser un deuxième test (203) électrique de ladite puce électronique (P) avec ladite puce électronique (P) dans une deuxième position (Pb) dans ledit logement (110), la deuxième position (Pb) étant telle que la première face de ladite puce électronique (P) soit en appui sur la première portion (110a) dudit au moins un logement (110).

4. Dispositif selon la revendication 1, ou système selon la revendication 2, ou procédé selon la revendication 3, dans lequel :
la deuxième position (Pb) de ladite au moins une puce électronique (P) est obtenue lorsque le dispositif de test (11) est dans une première orientation dans laquelle une face externe de la première partie (11a) du dispositif de test (11) est orientée vers le bas, la face externe comprenant ladite au moins une ouverture (11e) ; et
la première position (Pa) est obtenue lorsque la face externe de la première partie (11a) du dispositif de test (11) est orientée vers le haut.

5. Dispositif, ou système, ou procédé selon la revendication 3 ou 4, dans lequel, dans la première position (Pa), la première face (Pc) de ladite au moins une puce électronique (P) est éloignée de la première portion (110a) d'une distance (D1) supérieure à 100 micromètres.

6. Dispositif selon l'une quelconque des revendications 1, 4 à 5, ou système selon l'une quelconque des revendications 2, 4 à 5, ou procédé selon l'une quelconque des revendications 3 à 5, dans lequel la première portion (110a) est en forme de grille (11f) comprenant plusieurs desdites premières ouvertures (11e).

7. Dispositif selon l'une quelconque des revendications 1, 4 à 6, ou système selon l'une quelconque des revendications 2, 4 à 6, ou procédé selon l'une quelconque des revendications 3 à 6, dans lequel la première et la deuxième partie (11a, 11b) du dispositif de test (11) sont adaptées à être fixées ensemble avec au moins un organe de fixation (11h).

8. Dispositif selon l'une quelconque des revendications 1, 4 à 7, ou système selon l'une quelconque des revendications 2, 4 à 7, ou procédé selon l'une quelconque des revendications 3, 4 à 7, dans lequel le dispositif de test (11) est formé dans un matériau restant dans un état solide à 250°C, par exemple choisi parmi un métal, un alliage métallique, un oxyde, un fluoropolymère, un polyimide et un polyamide.

9. Système (100) selon l'une quelconque des revendications 2, 4 à 8, dans lequel le couvercle (12) comprend au moins un ergot (12a) appliquant ladite force à travers au moins une deuxième ouverture (11c), formée dans une deuxième portion (110b) comprise dans ledit au moins un logement (110), appartenant à la deuxième partie (11b) du dispositif de test (11), lorsque la base (13) collabore avec le dispositif de test (11) et le couvercle (12).

10. Système (100) selon l'une quelconque des revendications 2, 4 à 9, dans lequel la base (13) ou le couvercle (12) comprend des bras pivotants aptes à s'engager respectivement avec le couvercle (12) ou la base (13) lorsque ladite base (13) collabore avec le dispositif de test (11) et le couvercle (12).

11. Système (100) selon l'une quelconque des revendications 2, 4 à 10, comprenant en outre :
un circuit imprimé (20), sur lequel la base (13) est positionnée (20) ; et
un circuit de commande de test (21) couplé à au moins un contacteur électrique (13a) de la base (13) par l'intermédiaire dudit circuit imprimé.

12. Procédé selon l'une quelconque des revendications 3 à 8, dans lequel le deuxième test (203) comprend :
- fournir un couvercle (12) amovible par rapport au dispositif de test (11) ;
- fournir une base (13), adaptée à collaborer de façon amovible avec le dispositif de test (11) et le couvercle (12) ;
- appliquer une force sur ladite au moins une puce électronique (P) en faisant collaborer ladite base (13) avec le dispositif de test (11) et le couvercle (12).

13. Procédé selon l'une quelconque des revendications 3 à 8 et 12 dans lequel le premier test (202) comprend l'application d'une température supérieure à 250°C.

14. Procédé selon l'une quelconque des revendications 3 à 8, 12 et 13 dans lequel le premier test (202) comprend l'application d'un taux d'humidité supérieur à 60%.

## Patentansprüche

1. Testvorrichtung (11) für elektronische Dies (P), aufweisend:
einen ersten Teil (11a) und einen zweiten Teil (11b), die abnehmbar miteinander verbunden werden können und geeignet sind, zusammen mindestens ein Gehäuse (110) zu definieren, in dem mindestens ein elektronischer Die (P), der Kontaktelemente (P1) aufweist, zum Testen angeordnet werden kann;
wobei das mindestens eine Gehäuse (110) einen ersten Abschnitt (110a) aufweist, der zu dem ersten Teil (11a) gehört und mit mindestens einer ersten Öffnung (11e) versehen ist, die von mindestens einem elektrischen Kontaktgeber (13a) außerhalb der Testvorrichtung (11) durchquert werden kann;
wobei das mindestens eine Gehäuse (110) so beschaffen ist, dass der mindestens eine elektronische Die (P) folgende Positionen einnehmen kann
eine erste Position (Pa) in dem Gehäuse (110), in der eine erste Oberfläche (Pc) des elektronischen Dies (P), der die Kontaktelemente (P1) aufweist, von dem ersten Abschnitt (110a) entfernt ist, und
eine zweite Position (Pb) in dem Gehäuse (110), in der die erste Oberfläche (Pc) an dem ersten Abschnitt (110a) des mindestens einen Gehäuses (110) anliegt.

2. System (100) zum Testen von elektronischen Dies (P), aufweisend:
- die Testvorrichtung (11) nach Anspruch 1;
- eine von der Testvorrichtung (11) abnehmbare Abdeckung (12) ;
- eine Basis (13), die geeignet ist mit der Testvorrichtung (11) und der Abdeckung (12) zusammenzuwirken;
wobei die Testvorrichtung (11), die Abdeckung (12) und die Basis (13) so beschaffen sind, dass eine Kraft auf den mindestens einen elektronischen Die (P) ausgeübt wird, wenn die Basis (13) mit der Testvorrichtung (11) und der Abdeckung (12) zusammenwirkt.

3. Verfahren zum Testen elektronischer Dies (P), aufweisend:
- Anordnen von mindestens einem zu testenden elektronischen Die (P), der Kontaktelemente (P1) aufweist, in mindestens einem Gehäuse (110), das zwischen einem ersten Teil (11a) und einem zweiten Teil (11b) einer Testvorrichtung (11) definiert ist, wobei der erste und der zweite Teil (11a, 11b) in Bezug zueinander entfernbar sind, wobei das mindestens eine Gehäuse (110) einen ersten Abschnitt (110a) aufweist, der zum ersten Teil (11a) gehört und mit mindestens einer ersten Öffnung (11e) versehen ist, die von mindestens einem elektrischen Kontaktgeber (13a) außerhalb der Testvorrichtung (11) durchquert werden kann;
- Ausführen eines ersten Tests (202) des elektronischen Dies (P), wobei sich der elektronische Die (P) in einer ersten Position (Pa) in dem Gehäuse (110) befindet, wobei die erste Position (Pa) derart ist, dass eine erste Oberfläche (Pa) des elektronischen Dies (P), die die Kontaktelemente (P1) aufweist, von dem ersten Teil (110a) entfernt ist; und
- Ausführen eines zweiten elektrischen Tests (203) des elektronischen Dies (P), wobei sich der elektronische Die (P) in einer zweiten Position (Pb) in dem Gehäuse (110) befindet, wobei die zweite Position (Pb) derart ist, dass die erste Oberfläche des elektronischen Dies (P) an dem ersten Abschnitt (110a) des mindestens einen Gehäuses (110) anliegt.

4. Vorrichtung nach Anspruch 1, wobei:
die zweite Position (Pb) des mindestens einen elektronischen Dies (P) erreicht wird, wenn sich die Testvorrichtung (11) in einer ersten Ausrichtung befindet, in der eine Außenfläche des ersten Teils (11a) der Testvorrichtung (11) nach unten weist, wobei die Außenfläche die mindestens eine Öffnung (11e) aufweist; und
die erste Position (Pa) erreicht ist, wenn die Außenfläche des ersten Teils (11a) der Testvorrichtung (11) nach oben weist.

5. Vorrichtung nach Anspruch 1 oder 4, wobei in der ersten Position (Pa) die erste Oberfläche (Pc) des mindestens einen elektronischen Dies (P) von dem ersten Abschnitt (110a) um einen Abstand (D1) von mehr als 100 Mikrometern entfernt ist.

6. Vorrichtung nach einem der Ansprüche 1, 4 bis 5, wobei der erste Abschnitt (110a) die Form eines Gitters (11f) mit einer Vielzahl von ersten Öffnungen (11e) hat.

7. Vorrichtung nach einem der Ansprüche 1, 4 bis 6, wobei der erste und der zweite Teil (11a, 11b) der Testvorrichtung (11) angepasst sind, um mit mindestens einem Befestigungselement (11h) aneinander befestigt werden zu können.

8. Vorrichtung nach einem der Ansprüche 1, 4 bis 7, wobei die Testvorrichtung (11) aus einem Material gebildet ist, das bei 250°C in einem festen Zustand verbleibt, beispielsweise ausgewählt aus einem Metall, einer Metalllegierung, einem Oxid, einem Fluorpolymer, einem Polyimid und einem Polyamid.

9. System (100) nach Anspruch 2, wobei die Abdeckung (12) mindestens einen Zapfen (12a) aufweist, der die Kraft durch mindestens eine zweite Öffnung (11c) ausübt, die in einem zweiten Abschnitt (110b) ausgebildet ist, der in dem mindestens einen Gehäuse (110) enthalten ist, das zu dem zweiten Teil (11b) der Testvorrichtung (11) gehört, wenn die Basis (13) mit der Testvorrichtung (11) und der Abdeckung (12) zusammenwirkt.

10. System (100) nach Anspruch 2 oder 9, bei dem die Basis (13) oder die Abdeckung (12) Schwenkarme aufweist, die in der Lage sind, jeweils mit der Abdeckung (12) oder der Basis (13) in Eingriff zu kommen, wenn die Basis (13) mit der Testvorrichtung (11) und der Abdeckung (12) zusammenwirkt.

11. System nach einem der Ansprüche 2, 9 bis 10, ferner aufweisend:
eine gedruckte Schaltung (20), auf der die Basis (13) angeordnet ist; und
eine Test-Steuerschaltung (21), die über die gedruckte Schaltung mit mindestens einem elektrischen Kontaktgeber (13a) der Basis (13) verbunden ist.

12. Verfahren nach Anspruch 3, wobei der zweite Test (203) Folgen des aufweist:
- Bereitstellen einer von der Testvorrichtung (11) abnehmbaren Abdeckung (12);
- Bereitstellen einer Basis (13), die geeignet ist, mit der Testvorrichtung (11) und der Abdeckung (12) abnehmbar zusammenzuwirken;
- Aufbringen einer Kraft auf den mindestens einen elektronischen Die (P), indem die Basis (13) mit der Testvorrichtung (11) und der Abdeckung (12) zusammenwirkt.

13. Verfahren nach Anspruch 3 oder 12, wobei der erste Test (202) das Anlegen einer Temperatur von mehr als 250°C aufweist.

14. Verfahren nach einem der Ansprüche 3, 12 und 13, wobei der erste Test (202) das Anlegen einer Feuchtigkeitsrate von mehr als 60 % aufweist.

## Claims

1. Device (11) for testing electronic dies (P) comprising:
a first part (11a) and a second part (11b), which can be removably assembled to each other and adapted to defining together at least one housing (110) where at least one electronic die (P), comprising contacting elements (P1), can be arranged to be tested;
said at least one housing (110) comprising a first portion (110a), belonging to the first part (11a) and provided with at least one first opening (11e) capable of being crossed by at least one electric contactor (13a) external to the testing device (11);
said at least one housing (110) being arranged to enable said at least one electronic die (P) to occupy:
a first position (Pa) in said housing (110), where a first surface (Pc) of said electronic die (P), comprising the contacting elements (P1), is distant from the first portion (110a), and
a second position (Pb) in said housing (110), where the first surface (Pc) bears against the first portion (110a) of said at least one housing (110).

2. System (100) for testing electronic dies (P), comprising:
- the testing device (11) according to claim 1;
- a cover (12) removable from the testing device (11);
- a base (13) adapted to collaborating with the testing device (11) and the cover (12);
the testing device (11), the cover (12), and the base (13) being such that a force is applied to said at least one electronic die (P) when the base (13) collaborates with the testing device (11) and the cover (12).

3. Method of testing electronic dies (P) comprising:
- arranging at least one electronic die (P) to be tested, comprising contacting elements (P1), in at least one housing (110) defined between a first part (11a) and a second part (11b) of a testing device (11), the first and second parts (11a, 11b) being removable with respect to each other, said at least one housing (110) comprising a first portion (110a), belonging to the first part (11a), and provided with at last one first opening (11e) capable of being crossed by at least one electric contactor (13a) external to the testing device (11);
- carrying out a first test (202) of said electronic die (P) with said electronic die (P) in a first position (Pa) in said housing (110), the first position (Pa) being such that a first surface (Pa) of said electronic die (P), comprising the contacting elements (P1), is distant from the first portion (110a); and
- carrying out a second electrical test (203) of said electronic die (P) with said electronic die (P) in a second position (Pb) in said housing (110), the second position (Pb) being such that the first surface of said electronic die (P) bears against the first portion (110a) of said at least one housing (110).

4. Device according to claim 1, wherein:
the second position (Pb) of said at least one electronic die (P) is obtained when the testing device (11) is in a first orientation where an outer surface of the first part (11a) of the testing device (11) faces downwards, the outer surface comprising said at least one opening (11e); and
the first position (Pa) is obtained when the outer surface of the first part (11a) of the testing device (11) faces upwards.

5. Device according to claim 1 or 4, wherein, in the first position (Pa), the first surface (Pc) of said at least one electronic die (P) is distant from the first portion (110a) by a distance (D1) greater than 100 micrometers.

6. Device according to any of claims 1, 4 to 5, wherein the first portion (110a) is in the form of a grid (11f) comprising a plurality of said first openings (11e).

7. Device according to any of claims 1, 4 to 6, wherein the first and the second part (11a, 11b) of the testing device (11) are adapted to being attached together with at least one attachment member (11h).

8. Device according to any of claims 1, 4 to 7, wherein the testing device (11) is formed in a material remaining in a solid state at 250°C, for example, selected from among a metal, a metal alloy, an oxide, a fluoropolymer, a polyimide, and a polyamide.

9. System (100) according to claim 2, wherein the cover (12) comprises at least one spur (12a) applying said force through at least one second opening (11c), formed in a second portion (110b) comprised within said at least one housing (110), belonging to the second part (11b) of the testing device (11), when the base (13) collaborates with the testing device (11) and the cover (12).

10. System (100) according to claim 2 or 9, wherein the base (13) or the cover (12) comprises pivoting arms capable of respectively engaging with the cover (12) or the base (13) when said base (13) collaborates with the testing device (11) and the cover (12).

11. System according to any of claims 2, 9 to 10, further comprising:
a printed circuit (20), having the base (13) positioned thereon; and
a test control circuit (21) coupled to at least one electric contactor (13a) of the base (13) via said printed circuit.

12. Method according to claim 3, wherein the second test (203) comprises:
- providing a cover (12) removable from the testing device (11) ;
- providing a base (13), adapted to removably collaborating with the testing device (11) and the cover (12);
- applying a force to said at least one electronic die (P) by having said base (13) collaborate with the testing device (11) and the cover (12).

13. Method according to claim 3 or 12, wherein the first test (202) comprises the application of a temperature greater than 250°C.

14. Method according to any of claims 3, 12 and 13, wherein the first test (202) comprises the application of a moisture rate greater than 60%.
